(19) Europäisches Patentamt
European Patent Office
Office européen des brevets

(11) **EP 1 881 085 A2**

## (12) EUROPEAN PATENT APPLICATION

(43) Date of publication:
**23.01.2008 Bulletin 2008/04**

(51) Int Cl.:
*C23C 14/28* [(2006.01)]       *C23C 14/54* [(2006.01)]

(21) Application number: **07013108.1**

(22) Date of filing: **04.07.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK YU**<br><br>(30) Priority: **05.07.2006 US 818289 P**<br>　　　　　　　**02.03.2007 US 712924**<br><br>(71) Applicant: **Imra America, Inc.**<br>**Ann Arbor, MI 48105 (US)** | (72) Inventors:<br>• **Liu, Bing**<br>　**48105 Ann Arbor, Michigan (US)**<br>• **Hu, Zhendong**<br>　**48105 Ann Arbor, Michigan (US)**<br>• **Che, Yong**<br>　**48105 Ann Arbor, Michigan (US)**<br><br>(74) Representative: **Epping - Hermann - Fischer**<br>**Patentanwaltsgesellschaft mbH**<br>**Ridlerstrasse 55**<br>**80339 München (DE)** |

### (54) A method for producing and depositing nanoparticles

(57)　The present invention provides a one-step process for producing and depositing size-selected nanoparticles onto a substrate surface using ultrafast pulsed laser ablation of solid target materials. The system includes a pulsed laser with a pulse duration ranging from a few femtoseconds to a few tens of picoseconds, an optical setup for processing the laser beam such that the beam is focused onto the target surface with an appropriate average energy density and an appropriate energy density distribution, and a vacuum chamber in which the target and the substrate are installed and the background gases and their pressures are appropriately adjusted.

FIG 2

EP 1 881 085 A2

## Description

Field of the Invention

This application claims benefit of Provisional Application No. 60/818,289 filed July 5, 2006 and Non-Provisional Application No. 11/712,924 filed March 2, 2007; the disclosure of which are incorporated herein by reference.

This invention is related to a process of producing and depositing size-selected metal and metal oxide nanoparticles onto a substrate surface using ultrafast pulsed laser ablation.

Description of the Prior Art and Background of the Invention

Nanoparticles of various materials such as metal, metal oxide, and semiconductors have recently attracted much attention from academia and industry because of their unique chemical and physical properties which dramatically differ from those of their bulk counterparts. Promising applications of nanoparticles have been explored in many areas, including magnetics, photonics, catalysts, sensors, and biomedicines. However, the synthesis of nanoparticles in a controlled manner, in terms of impurities, stoichiometry, crystallinity, homogeneity, and size uniformity, is still a challenge for practical applications.

In general, methods of producing nanoparticles can be put into two categories: chemical method (wet process) and physical method (dry process). Examples of the chemical method are sol-gel and reverse micelles. Examples of the physical method are ion implantation, sputtering, and spray pyrolysis. Chemical methods often result in aggregations of nanoparticles, and impurities introduced by the organic solvents and additives is also a problem. Physical methods usually do not have satisfactory control over the particle size and homogeneity.

Recently, pulsed laser ablation, as one of the physical methods, has appeared as a promising technique for producing nanoparticles because of its flexibility and robustness in process control, e.g., easy and accurate control over the critical experimental parameters such as laser pulse energy, repetition rate, temperature, and background gas species and pressure. See, e.g., T. Sasaki, S. Terauchi, N. Koshizaki, and H. Umehara, AIChE Journal, Ceramics Processing, Vol. 43, No. 11A, 2636, 1997 and Happy, S. R. Mohanty, P. Lee, T. L. Tan, S. V. Springham, A. Patran, R. V. Ramanujan and R. S. Rawat, Applied Surface Science, Vol. 252, No. 8, 2806, 2006. Another important feature of pulsed laser ablation is that nanoparticles of a variety of materials, such as metals, alloys, metal oxides, and semiconductors can all be produced in a very clean manner and with complex compositions. However, in spite of the advantages of pulsed laser ablation in the production of nanoparticles, processes developed with a clear understanding of the critical parameters that determine the particle characteristics are not yet available.

The conventional pulsed laser ablation methods mostly employ nanosecond pulse lasers, such as excimer or Q-switched Nd:YAG lasers. The laser irradiation heats the material surface, leading to surface melting and vaporization. At sufficient irradiance, the vapor can become ionized, and a plasma is formed (which is called a plume). It should be noted that the nanosecond pulsed laser ablation process by itself only generates sparse particles, which are often large. Most nanoparticles are formed at a later stage where the ablated vapor is forced to condense in a background gas of a high pressure (a few torr). This is essentially the same as all other vapor condensation methods, and the resultant particles often have sizes ranging from a few nanometers to a few hundreds of nanometers, which are unfit for many nanoparticle applications.

A recent publication, Y. Naono, S. Kawabata, S. H. Hah, and A. Nakajima, Science and Technology of Advanced Materials, Vol. 7, No. 2, 209, 2006, provides a technique that can select desirable nanoscale particle sizes using a combination of a low pressure differential mobility analyzer (LP-DMA) and nanosecond pulsed laser ablation. In this technique, the nanoparticles generated by pulsed laser ablation, which have a broad size distribution, are transported to a LP-DMA chamber by a carrier gas. The particles are then charged and selected according to their mobility (which is size-dependent). However, because this technique rejects a large portion of the produced particles of undesired sizes, the yield of desired nanoparticles is very low.

A few prior patent applications (US 2006/0049034 A1, US 2006/0049547 A1, EP 1308418 A1, JP 2003-306319) also provide methods for producing nanoparticles by employing nanosecond pulsed lasers. However, in those approaches, the generation, transportation and collection (deposition) of nanoparticles are in separated process stages, and the loss between stages leads to a very low yield.

With the commercial availability of ultrafast pulsed lasers (with typical pulse durations ranging from a few femtoseconds to tens of picoseconds), ultrafast pulsed laser ablation has attracted much attention. Due to the extremely short pulse duration and the resultant high peak power density, the critical fluence of ablation is reduced by 1-2 orders of magnitude compared with nanosecond pulsed laser ablation, and as a result, the commonly favored ultraviolet wavelength (which is expensive to obtain) in nanosecond pulsed laser ablation is no longer a requirement in ultrafast pulsed laser ablation. A prior patent (US RE 37,585 E) provides a guideline for realizing efficient laser ablation within a regime of low breakdown threshold by selecting appropriate pulse duration.

More recently, theoretical and experimental studies have suggested that ultrafast pulsed laser ablation also generates nanoparticles, but with a fundamentally different mechanism from those processes using longer (nanosecond) pulses. F. Vidal, T. W. Johnston, S. Lavillen, O. Barthelemy, M. Chaker, B. Le Drogoff, J. Margot, and M. Sabsabi, Physical Review Letters, Vol. 80, No, 12, 2573, 2001, S. Eliezer, N. Eliaz, E. Grossman, D. Fisher, I. Couzman, Z. Henis, S. Pecker, Y. Horovitz, M. Fraenkel, S. Maman, and Y. Lereah , Physical Review B, Vol 69, 144119, 2004, and S. Amoruso, R. Bruzzese, N. Spinelli, R. Velotta, M. Vitiello, X. Wang, G. Ausanio, V. Iannotti, and Lanotte, Applied Physics Letters, Vol. 84, No. 22, 4502, 2004. In ultrafast pulsed laser ablation, nanoparticles are generated as a result of automatic phase transition near the critical point of the material under irradiation, which is only reachable through ultrafast heating and the subsequent cooling. Also, unlike the forced condensation process in nanosecond pulsed laser ablation, which occurs long after the ablation is over, the nanoparticle generation in ultrafast pulsed laser ablation takes place at a very early stage during ablation (less than one nanosecond after the laser pulse hits the target), and the nanoparticles fly out in a very directional manner. These features in principle should enable a one-step process that includes both the particle generation and deposition. The present invention, based on the fundamental uniqueness of ultrafast pulsed laser ablation and the inventors' systematic investigation of the correlation between experimental parameters and nanoparticle characteristics, provides a one-step process to produce and deposit size-selected nanoparticles in a practically controllable manner.

Summary of the Invention

This invention is related to producing nanoparticles using ultrafast pulsed laser ablation. This invention first provides a method of producing nanoparticles with controllable particle size distributions using ultrafast pulsed laser ablation. This invention also provides a method of efficient utilization of the source material to form nanoparticles with high yield, i.e., a high mass fraction (>10%, preferably >40%) between nanoparticles and the total removed material from the target, which is important especially when the material is expensive, e.g., precious metals. It is also important to keep a high mass fraction (>10%, preferably >40%) of nanoparticles over the total deposited mass, including the thin-film form, on the substrate, so that the nanoparticles could be kept in desired size ranges and exhibit their unique properties. Another advantage of this method is that it can be universally applied to almost all kinds of materials, including metals, alloys, semiconductors, metal oxides, and polymers.

Although ultrafast pulsed laser ablation is a promising method of generating nanoparticles, as introduced in the previous section, in the current inventors' experiences with ultrafast pulsed laser ablation, the particle size distribution is still very wide, ranging from a few nanometers to a few hundreds of nanometers. It should be noted that in the field of nanoparticle science and technology, the term 'nano' refers preferably to sizes less than 20 nm. Accordingly, larger scales (from a few tens of nanometers up to 1 micron) are often referred to as the mesoscale, where the physical properties of a material become closer to its bulk properties. In this specification, we follow this convention of referring to the scale of sizes: by nanoparticles we mean particle sizes equal to and less than 20 nm. Larger particles (with diameters up to 1 micron) are referred to as mesoparticles.

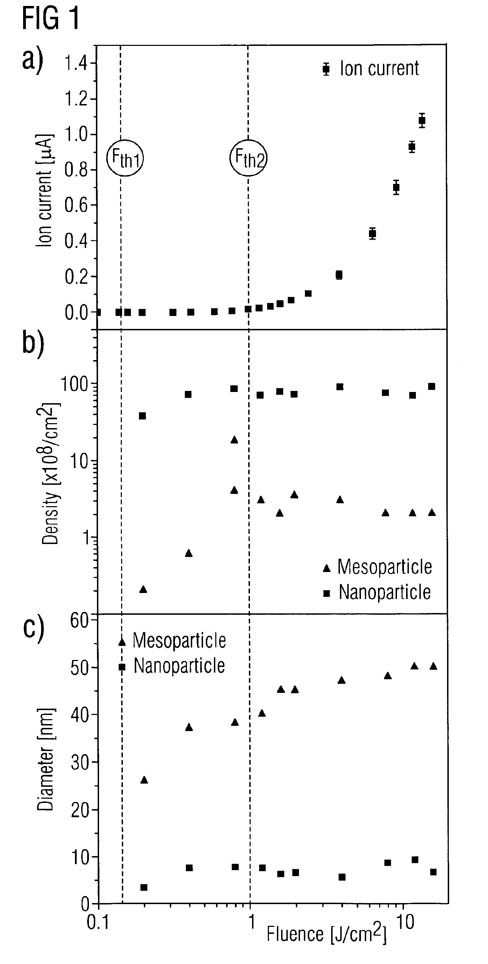

The method of controlling the particle size distribution and maximizing the yield in the current invention lies in controlling the fluence (energy area density at the laser focal spot) to a range between two thresholds ($F_{th1}$ and $F_{th2}$, see FIG. 1), in which the mesoparticles can be largely eliminated and a good yield can be obtained. The lower threshold ($F_{th1}$) is the one at which the solid material starts to break down under the intense laser irradiation. Below this threshold, no significant material removal occurs. Above the high threshold ($F_{th2}$), the size and density of the mesoparticles stabilizes and a significant amount of removed material is transformed into plasma. Because of the strong plasma formation at high fluences, a practically easy way to recognize $F_{th2}$ is to plot the ion current ($i$), which can be easily measured using an ion probe during ablation, as a function of the laser fluence ($F$). $F_{th2}$ is recognizable at the turning point in the $i$-$F$ plot, above which the ion current starts to gain significantly with the fluence [for example, see FIG 1(c)]. $F_{th1}$ is recognizable as the fluence at which the particle yield (size and density) asymptotically approaches zero. Although $F_{th2}$ is the preferable high threshold, fluences up to around $3F_{th2}$ can be tolerated in situations where the end-use application is relatively insensitive to the presence of mesoparticles.

As discussed above, one consequence of plasma formation is that the mass fraction of nanoparticles in the total mass of the material removed from the target or the total mass deposited on the substrate decreases with the increasing laser fluence. Particularly, by using a laser fluence between $F_{th1}$ and $F_{th2}$ the ablated material is mostly composed of nanoparticles, and for applications where the presence of some mesoparticles and atomic species does not significantly affect performance, the fluence range for particle generation can be extended up to $3F_{th2}$. On the other hand, by using a laser fluence above $3F_{th2}$, the ablated material is mostly in the form of gas with negligible amounts of particles. Therefore, nanocomposite thin-films, which are composed of nanoparticles embedded in thin films, and superlattice structures with alternatively deposited nanoparticles and thin-films, can be fabricated by modulating the laser fluence between two regimes, i.e., below and above $3F_{th2}$. In addition, a variety of material combinations can also be easily realized by shifting between target materials inside the chamber.

That the appearance of a stabilized mesoparticle population is coincident with the threshold $F_{th2}$ sug-

gests that the formation of the mesoparticles is related to high laser fluences. It should be noted that the $TEM_{00}$ mode used by most ultrafast lasers has a Gaussian type intensity distribution at the beam cross-section (and also at the focal spot), where the center of the beam has a much higher intensity (and therefore a higher fluence) than the edge. Considering this laser beam property, this invention also transforms the laser beam from a Gaussian profile to a "flat-top" profile to realize a uniform fluence on the target surface. A "flat-top" profile is also advantageous to further control the particle size distribution and improve the yield.

A further aspect of the invention relates to the employment of gases during ultrafast pulsed laser ablation. A sufficient pressure of background gas can speed up cooling and solidification of the nanoparticles, which otherwise may remain as liquid droplets when traveling in vacuum, and upon landing on the substrate surface, change their size, shape, and structural qualities. For example, an inert gas can assist rapid solidification, and a reactive gas can aid in the formation of compound nanoparticles. These features of the invention are described below in detail.

Brief Description of the Drawings

FIG. 1. is a three-part graphic diagram where part (a) is a plot of ion current versus laser fluence where thresholds. Part (b) illustrates particle density dependence on fluence, and part (c) illustrates particle size dependence on fluence. Filled triangles represent mesoparticles; filled circles represent nanoparticles in parts (b) and (c). $F_{th1}$ and $F_{th2}$ are indicated by the two vertical dashed lines.

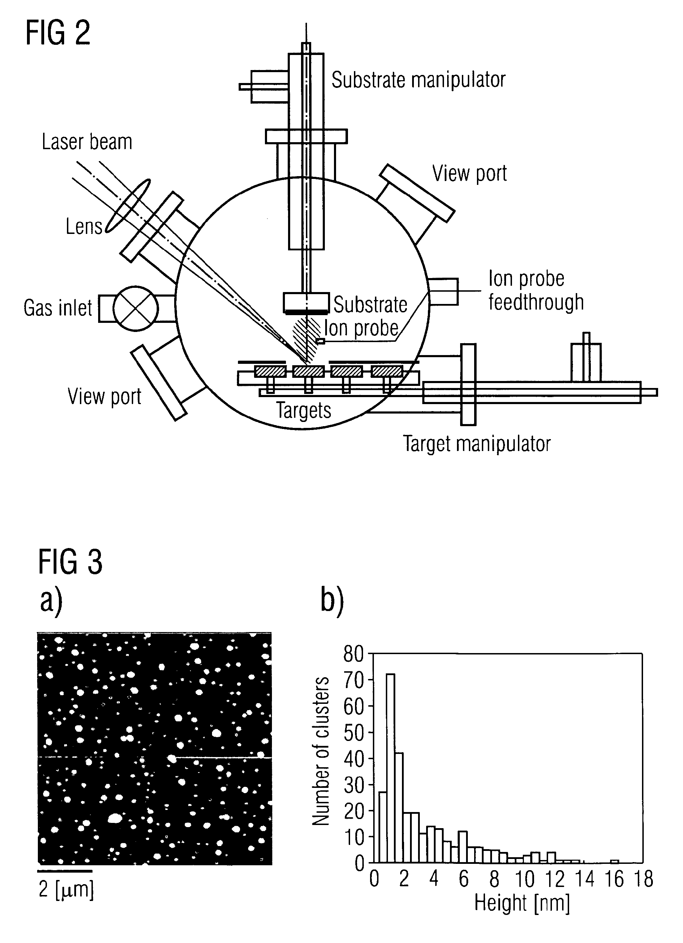

FIG. 2. illustrates the system of the invention including a vacuum chamber (and related pumps, not shown), a target manipulator, an ion probe (Langmuir probe), a gas inlet, and a substrate manipulator, where the laser beam is focused onto the target surface through a fused silica window.

FIG. 3. is a two part diagram wherein part (a) is an AFM image ofNi nanoparticles generated at a fluence of 0.4 J/cm$^2$ and part (b) shows the particle size distribution.

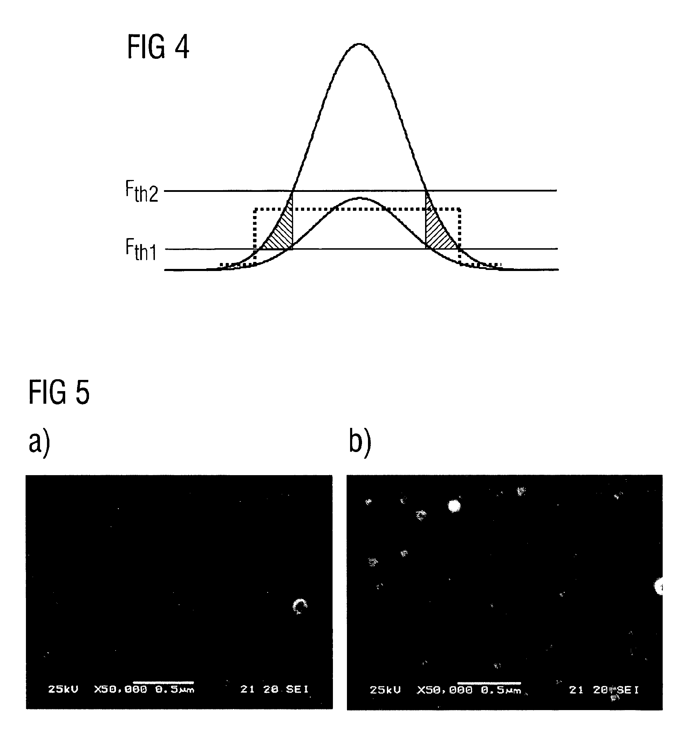

FIG. 4. illustrates the conventional Gaussian intensity distribution of a laser beam, where thresholds are indicated as horizontal lines. Above $F_{th2}$, at the center of a focal spot, the laser is intense enough to fully vaporize the material, which reduces the yield of nanoparticles. The tall and short curve illustrate an intense and a weak beam profile, respectively. The dotted square line illustrates a flat-top beam profile.

FIG. 5. is a two part diagram proving a comparison of the background gas effect: in part (a) CoO particles are generated in vacuum; in part (b) CoO particles are generated in 30 millitorr Argon.

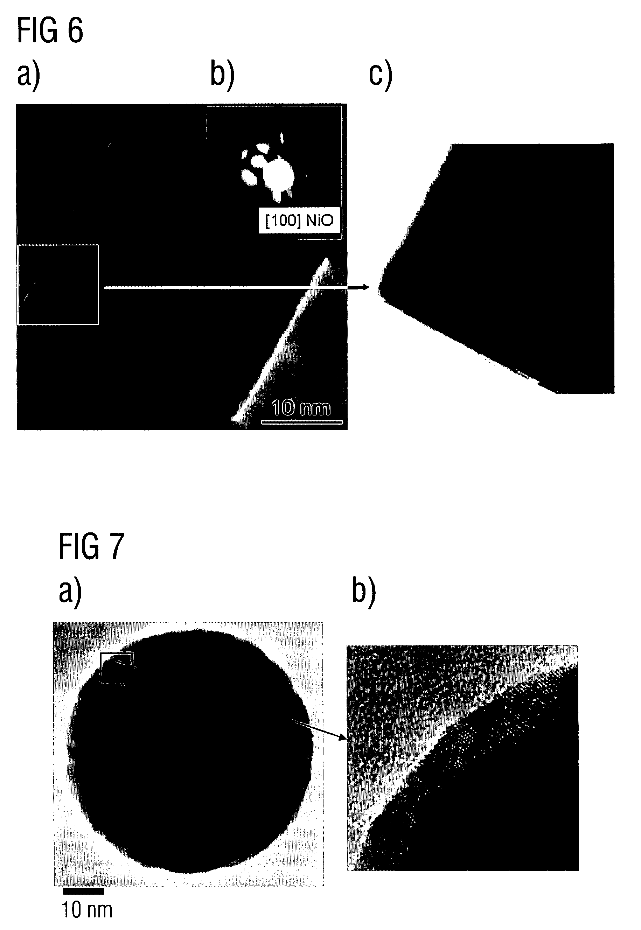

FIG. 6. is a three part HRTEM image of a NiO nanoparticle obtained in 30 millitorr oxygen by ultrafast laser ablation of a metal Ni target, where parts (a) and (c) are high resolution images which show the single crystal structures and part (b) is a nanoelectron beam diffraction pattern which shows the NiO (100) diffraction.

FIG. 7. is a two part diagram showing HRTEM images of a nanoparticle with a structure that has a Ni core and NiO shell. This is obtained by first ablating a metal Ni target in 30 millitorr argon and then exposing the sample to oxygen at room temperature. The core-shell structure is evident in part (b). FFT analysis confirms the core shell structure.

Detailed Description of the Invention

Figure 2 illustrates the system used in this invention. The system includes a vacuum chamber 1 pumped by a turbo pump and a mechanical pump (not shown), a target manipulator 2 which provides for rotational and lateral movement for four targets of different materials, a substrate manipulator 3 which provides heating and rotational and lateral movements for the substrate 10, a gas inlet 4, and an ion probe 6 (Langmuir probe) to measure the ion current of the ablation plume. When measuring the ion current, the ion probe is biased -50 V relative to the ground to collect the positive ions in the plume (the number of negative ions in plasma is negligible). An ultrafast laser (not shown in the figure) is positioned outside the chamber and the laser beam 20 is focused onto the target surface through a fused silica window 21. The laser has a pulse duration between 10 fs - 50 ps, preferably between 10 fs - 1 ps; a pulse energy between 100 nJ - 10 mJ; and a repetition rate greater than 1 kHz. The metal nickel and metal oxide CoO are used as example materials in this invention, but this invention is not limited to these materials, because the physics behind particle formation during ultrafast pulsed laser ablation applies similarly to both metals and insulators (including semiconductors, metal oxides, and polymers).

Figure 1 (a) shows the collected ion current (i) versus the laser fluence (F). It is clearly recognizable that above a fluence of about 1.0 J/cm$^2$, the ion current gains significantly with the fluence, while below this value, the ion current is nearly vanishing. This behavior of the ion current can be understood by considering ultrafast pulsed laser ablation of metals in several generalized stages: (1) electrons gaining energy from the intense laser irradiation, (2) electron thermalization with the lattice (here lattice means the atoms that constitute the solid target), (3) breakdown of the chemical bonds and formation of plasma, and (4) cooling and expansion of the plasma into a vacuum. For ultrafast pulsed laser ablation, stages (1) and (2) occur within a few picoseconds and have been described by the so-called two-temperature model, which predicts that after electron-lattice thermalization, the system temperature $T$ is proportional to the fluence, and the ablation depth ($L$) is related to the fluence through

$$L \sim (D\tau)^{1/2} ln(F/F_{th1}),$$

where $D$ is the thermal diffusivity and $\tau$ is the pulse duration. (See, S. Nolte, C. Momma, H. Jacobs, A Tunnermann, B. N. Chichkov, B. Wellegehausen and H. Welling, Journal of the Optical Society of America B, Vol 14, No. 10, 2716, 1997.) For stage (3) of ionization and plasma formation, for simplification, the Saha-Boltzmann equation can be applied, which predicts that for a low temperature plasma (which holds for most laboratory plasma), the ionization fraction $\alpha$ can be estimated as

$$\alpha^2 \sim n_o G(T) T^{3/2} exp(-U/T),$$

where $n_o$ represents the neutral density, $G(T)$ is a slow varying function of the temperature, and U is the first ionization energy of the constituent element. Combining the expressions for the ablation depth and the ionization fraction, the amount of ions can be estimated as $i \sim ALN\alpha$, where $A$ is the area of the focal spot and $N$ is the target material density. It is therefore understood that the fast increase of the ion current at high fluences is a result of a high level of ionization, which comes from a high temperature (after electron-lattice thermalization). If the temperature is close to the ionization energy U, intense plasma can be formed. Therefore an *i-F* plot provides an easy approach for estimating the threshold $F_{th2}$ of plasma generation, which is about 1.0 J/cm² in the case of FIG. 1(a).

Figures 1(b) and 1(c) display the density and particle size dependences on the fluence. It is seen that at high fluences, both types of particle acquire stabilized size and density, while at low fluences (<1.0 J/cm²), the size and density of the mesoparticles vanish quickly, and the size and density of the nanoparticles vanish very slowly. The threshold $F_{th1}$, below which no material removal occurs, can be found by extrapolating the size and density of both particles asymptotically to the horizontal (fluence) axis.

Therefore a combination of the data from FIGS. 1(a), (b), and (c) provides convenient and practical guidance for controlling the particle size distribution by setting the fluence below the plasma generation threshold $F_{th2}$ and above the fundamental breakdown threshold $F_{th1}$. Within this region, the large mesoparticles can mostly be eliminated, as exemplified in FIG.3, and significant plasma formation is avoided, which results in a good yield of nanoparticles.

Figure 3(a) is an AFM image of a sample obtained by placing a substrate 5 cm away from the target and collecting the particles for 1 min. The laser used in this example has a 1 kHz repetition rate; the fluence is 0.4 J/cm². It is seen that the particle size distribution peaks significantly at 1.6 nm, as shown in FIG. 3(b). In FIG. 3(b), the particle height is used to represent the particle size, assuming that the particle is a hard sphere. This assumption is valid because of the effects of cooling rates and the background gas, which will be discussed later.

That the appearance of mesoparticles is coincident with the beginning of strong plasma formation suggests a role played by the intensity distribution of the laser beam. The TEM$_{00}$ mode used by most ultrafast lasers has a Gaussian type intensity distribution. Figure 4 schematically illustrates an intense and a weak beam profile of Gaussian type. The two thresholds $F_{th1}$ and $F_{th2}$ are indicated by the two horizontal lines. For the intense beam profile (the taller curve), most of the center portion is above the plasma formation threshold $F_{th2}$, as a result, the materials exposed to the center of the focal spot will be mostly vaporized and transformed into plasma, and only the edge of the focal spot (the hatched area) is within the two thresholds and contributes to particle formation. Therefore, with the intense beam, first, the nanoparticle yield is low. Second, the vaporized center portion applies a strong recoil force to the melts and causes mesoscale liquid droplets to be splashed out, which is the source of the mesoparticles. On the other hand, for the less intense beam (the shorter curve), the center portion falls within the two thresholds and contributes to nanoparticle formation without causing much plasma generation. Optimally, a 'flat-top' beam profile (as illustrated by the dashed thick line) improves the control of particle size distribution and nanoparticle yield. Transformation of a Gaussian profile into a flat-top beam profile can be achieved with a number of known approaches, for example using diffractive optics.

Supplying a background gas of sufficient pressure can also help to improve the nanoparticle size distribution. In vacuum, the particles (after being formed during ablation) cool down through black-body radiation, which is an inefficient way of losing heat. It can be shown that for black-body radiation, the cooling rate *dT/dt* of a small spherical particle satisfies

$$dT/dt = -(3M/r\rho C_p)e\sigma(T^4 - T_0^4),$$

where $M$, $r$, $\rho$, and $C_p$ represent the molar mass, radius, and heat capacity of the material, $T_0$ is the ambient temperature (room temperature), e is the emissivity, and $\sigma$ is the Stephen-Boltzmann constant. It can therefore be estimated that for a Ni particle of a diameter of 10 nm, it takes on the order of 0.1 $\mu$s for the particle to cool from 2500 °C (a typical temperature reached by ultrafast pulsed laser ablation) to its melting point (1455 °C). This time scale may be shorter than the time it takes for the particles to reach the substrate, depending on the target-substrate distance. However, liquid-solid phase transition requires the release of the latent heat. Also, solidification also requires presence of nucleation centers for solidification to be initiated; otherwise the liquid will remain super-cooled even below its melting point. Therefore, it is possible that the particles can maintain the liquid state when flying in vacuum. And it is further possible in this case that the liquid particles can easily change shape or even break into pieces when smashing onto a hard substrate surface. Supplying the system with gas helps to cool down the flying particles by heat exchange during collision with the gas molecules. Collision can also provide density disturbance on the liquid droplet surface, which can introduce nucleation centers. These effects help the nanoparticles to solidify before they reach the substrate.

Figure 5 compares the shape of the nanoparticles obtained in vacuum [$1 \times 10^{-7}$ torr, FIG. 5(a)] and in 30 millitorr argon [FIG. 5(b)] under otherwise identical conditions. In this case, metal oxide CoO is used as the target material. It is evident that the background argon gas changes the shapes from shallow and smashed droplets to round ping-pong-ball-like hard spheres, and the particle sizes are also smaller because of the shape change.

When the background gas is reactive, for example oxygen, there are additional benefits that can help to bring in new chemical and structural properties. First, the ablated metal can react with oxygen during ablation to form metal oxide nanoparticles. Second, by simply exposing the metal particles to oxygen after ablation, nanoparticles with oxide shell and metal core structures can also be formed. Two examples are shown in FIG. 6 and FIG. 7.

Figure 6 shows HRTEM images of a Ni nanoparticle obtained by ultrafast pulsed laser ablation in 30 millitorr oxygen. It is evident that single crystal cubic NiO nanoparticles are formed, as clearly seen FIG. 6(c). This is also confirmed by electron beam diffraction in FIG. 6 (b), which displays the NiO(100) diffraction.

Another example is shown in FIG. 7. By first forming Ni nanoparticles in 30 millitorr argon and then exposing the nanoparticles to oxygen, nanoparticles with Ni-core-NiO-shell structures are obtained. The core-shell structures are especially evident in FIG. 7(b). Fast Fourier transformation analysis (not shown) performed at the shell and core regions also confirms the core-shell structures.

The scope of protection of the invention is not limited to the examples given hereinabove. The invention is embodied in each novel characteristic and each combination of characteristics, which particularly includes every combination of features which are set forth in the claims, even if this feature or this combination of features is not explicitly mentioned in the specification, the claims or in the examples.

## Claims

1. A method for producing and depositing nanoparticles, mesoparticles or a mixture thereof, using an ultrafast pulsed laser for ultrafast pulsed laser ablation of a material; and controlling the relative percentages of nanoparticles and mesoparticles in said mixture by controlling a fluence of said laser.

2. The method of claim 1, wherein the laser fluence is set between a first predetermined threshold and a second predetermined threshold.

3. The method of claim 2, wherein the first predetermined threshold is the material breakdown threshold $F_{th1}$

4. The method of claim 3, wherein the material breakdown threshold $F_{th1}$ is obtained by determining, for said material, the laser fluence level where the removed particle yield asymptotically approaches zero.

5. The method of one of claims 2 to 4, wherein the second predetermined threshold is the plasma formation threshold $F_{th2}$ of said material.

6. The method of claim 5, wherein the plasma formation threshold $F_{th2}$ of said material is determined by plotting the ion current collected by an ion probe as a function of the laser fluence, and recognizing the fluence at which the plot exhibits a distinct turning point of change in the slope, below which the ion current becomes vanishing.

7. The method of claim 5 or 6, wherein the second predetermined threshold is about 3 times larger than a plasma formation threshold $F_{th2}$ of said material.

8. A method for producing and depositing nanoparticles, mesoparticles or a mixture thereof, using an ultrafast pulsed laser for ultrafast pulsed laser ablation of a material; comprising the steps of providing a vacuum chamber containing a target and a substrate, irradiating the target with a pulsed laser beam generated by said ultrafast pulsed laser, said laser beam being processed and focused onto the target by an optical system.

9. The method of claim 8, wherein the optical system processes the intensity distribution of the laser beam from a Gaussian profile to a flat-top profile.

10. The method of claim 8 or 9, further comprising controlling a size distribution of said particles by controlling a laser fluence based on a predetermined relationship between the laser fluence and the particle size.

11. The method of claims 10, wherein said particles have sizes equal to or less than 1 micron and greater than one nanometer, and the percentage of the particle distribution within a size range equal to or less than 20 nanometers and greater than about one nanometer is controlled by controlling the fluence of said laser.

12. The method of claim 10 or 11, further including controlling said fluence so that a mass fraction of deposited particles of 20 nanometers or smaller size is equal to or higher than 10% over the total deposited mass of the material.

13. The method of claim 10 or 11, further including controlling said fluence so that a mass fraction of deposited particles of 20 nanometers or smaller size is equal to or higher than 40% over the total deposited mass of the material.

14. The method of one of claims 10 to 13, further comprising monitoring a plasma ion current during laser ablation with an ion probe, and indirectly monitoring said laser fluence using the ion current based on a predetermined relationship between laser fluence and plasma ion current.

15. The method of one of claims 1 to 14, wherein the said ultrafast pulsed laser has a pulse width of 10 fs-50 ps.

16. The method of one of claims 1 to 15, wherein the said ultrafast pulsed laser has a pulse width of 10 fs-1 ps.

17. The method of one of claims 1 to 16, wherein the said ultrafast pulsed laser has a pulse energy of 100 nJ- 1 mJ.

18. The method of one of claims 1 to 17, wherein the said ultrafast pulsed laser has a repetition rate of 1 kHz - 10 MHz.

19. The method of one of claims 1 to 18, wherein the ultrafast pulsed laser and the optical system enable a laser fluence in the range of 10 mJ/cm$^2$ - 10 J/cm$^2$, at the target surface.

20. The method of one of claims 1 to 19, comprising the step of performing laser ablation and deposition in a background gas that can be inert or reactive.

21. The method of one of claims 1 to 20, wherein said production and deposition of particles is performed at room temperature.

22. The method of one of claims 1 to 21, wherein said target comprises a metal, an alloy, and/or a metal oxide.

23. The method of one of claims 1 to 22, wherein said substrate comprises a metal, a metal oxide, a semiconductor material or carbon.

24. The method of one of claims 1 to 23, wherein said substrate is a glass or a polymer film.

25. The method of one of claims 1 to 24, wherein the said particles are metal particles, which are produced and deposited onto said substrate by ablating a metal target in vacuum or in inert background gas.

26. The method of one of claims 1 to 24, wherein the said particles are alloy particles, which are produced and deposited onto said substrate by ablating an alloy target in vacuum or in inert background gas.

27. The method of one of claims 1 to 24, wherein the said particles are metal compound particles, which are produced and deposited on the substrate by ablating a metal target in a reactive background gas.

28. The method of claims 1 to 24, wherein said particles are metal oxide particles, which are produced and deposited on the substrate by ablating a metal oxide target in vacuum or in background gas, which can be inert or reactive.

29. The method of one of claims 1 to 28, wherein the said particles are metal oxide particles, which are produced and deposited on the substrate by ablating a metal target in oxygen.

30. The method of claim 28 or 29, wherein the said particles have a core-shell structure with a metal core and a metal oxide shell.

31. The method of one of claims 1 to 24, wherein the said particles have a core-shell structure, which is produced by ablating a metal target in reactive background gas.

32. The method of claims 1 to 24 , wherein the said particles have a core-shell structure, which is produced by ablating a metal target in vacuum or inert background gas, and subsequently oxidized.

**33.** Apparatus for producing and depositing nanoparticles, mesoparticles or a mixture thereof, having a vacuum chamber containing a target and a substrate, an ultrafast pulsed laser for producing ultrashort laser pulses, and an optical system generating a laser beam which is processed to produce a non-Gaussian intensity distribution and focused on the target.

**34.** A deposition of particles having a controllable mass fraction of nanoparticles of a size equal to or less than 20 nanometers, wherein the mass fraction of said nanoparticles is equal to or higher than 10%.

**35.** The deposition of claim 34, wherein said mass fraction is equal to or higher than 40%.

# FIG 1

# FIG 2

Laser beam

Lens

Gas inlet

View port

Substrate manipulator

View port

Ion probe feedthrough

Substrate
Ion probe

Targets

Target manipulator

# FIG 3

## a)

2 [μm]

## b)

Number of clusters

Height [nm]

FIG 4

$F_{th2}$

$F_{th1}$

FIG 5

a)                                          b)

25kV    X50,000 0.5μm        21 20 SEI

25kV    X50,000 0.5μm        21 20 SEI

## FIG 6

a)    b)    c)

[100] NiO

10 nm

## FIG 7

a)    b)

10 nm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 60818289 A
- WO 11712924 A
- US 20060049034 A1
- US 20060049547 A1
- EP 1308418 A1
- JP 2003306319 A
- US RE37585 E

### Non-patent literature cited in the description

- **T. SASAKI ; S. TERAUCHI ; N. KOSHIZAKI ; H. UMEHARA.** *AIChE Journal, Ceramics Processing,* 1997, vol. 43 (11A), 2636
- **HAPPY, S. R. ; MOHANTY, P. ; LEE, T. ; L. TAN ; S. V. SPRINGHAM ; A. PATRAN ; R. V. RAMANUJAN ; R. S. RAWAT.** *Applied Surface Science,* 2006, vol. 252 (8), 2806
- **Y. NAONO ; S. KAWABATA ; S. H. HAH ; A. NAKAJIMA.** *Science and Technology of Advanced Materials,* 2006, vol. 7 (2), 209
- **F. VIDAL ; T. W. JOHNSTON ; S. LAVILLEN ; O. BARTHELEMY ; M. CHAKER ; B. LE DROGOFF ; J. MARGOT ; M. SABSABI.** *Physical Review Letters,* 2001, vol. 80 (12), 2573
- **S. ELIEZER ; N. ELIAZ ; E. GROSSMAN ; D. FISHER ; I. COUZMAN ; Z. HENIS ; S. PECKER ; Y. HOROVITZ ; M. FRAENKEL ; S. MAMAN.** *Physical Review B,* 2004, vol. 69, 144119
- **S. AMORUSO ; R. BRUZZESE ; N. SPINELLI ; R. VELOTTA ; M. VITIELLO ; X. WANG ; G. AUSANIO ; V. IANNOTTI ; LANOTTE.** *Applied Physics Letters,* 2004, vol. 84 (22), 4502
- **S. NOLTE ; C. MOMMA ; H. JACOBS ; A TUNNERMANN ; B. N. CHICHKOV ; B. WELLEGEHAUSEN ; H. WELLING.** *Journal of the Optical Society of America B,* 1997, vol. 14 (10), 2716